Europäisches Patentamt

European Patent Office

Office européen des brevets

(11) Veröffentlichungsnummer: **0 038 400**

**A1**

(12) # EUROPÄISCHE PATENTANMELDUNG

(21) Anmeldenummer: **81100705.3**

(22) Anmeldetag: **31.01.81**

(51) Int. Cl.³: **H 04 M 3/30**
**H 04 B 3/46, G 01 R 27/26**
**G 01 R 31/02**

(30) Priorität: **23.04.80 DE 3015517**

(43) Veröffentlichungstag der Anmeldung:
**28.10.81 Patentblatt 81/43**

(84) Benannte Vertragsstaaten:
**AT CH FR LI NL**

(71) Anmelder: **Felten & Guilleaume Carlswerk**
**Aktiengesellschaft**
**Schanzenstrasse 24 Postfach 80 50 01**
**D-5000 Köln 80(DE)**

(72) Erfinder: **Brüggendieck, Siegfried, Dipl.-Ing.**
**Amselweg 20**
**D-5608 Radevormwald(DE)**

(72) Erfinder: **Volkmann, Klaus, Dipl.-Ing.**
**Feldstrasse 121A**
**D-5060 Berg. Galdbach 2(DE)**

(72) Erfinder: **Hornig, Wolfgang, Dipl.-Ing.**
**Riesserseestrasse 21**
**D-8100 G.-Partenkirchen(DE)**

(54) **Verfahren und Kabelüberwachungssystem zur automatischen Überwachung eines Fernmeldekabelnetzes.**

(57) Es wird ein Verfahren und ein Kabelüberwachungssystem zur automatischen Überwachung eines Fermeldekabelnetzes angegeben.

Die Aufgabe besteht darin, das beginnende Stadium einer Verschlechterung des Betriebszustandes zu erkennen und anzuzeigen. Die Lösung besteht im wesentlichen darin, daß an den zu überwachenden Kabeln die Differenz der Betriebskapazität $\Delta C_B$ bei zwei verschiedenen Frequenzen $f_1$ und $f_2$ ermittelt wird, die gemessenen Werte mit vorgegebenen Grenzwerten verglichen werden und die Überschreitung eines Grenzwertes an eine Überwachungsstelle übermittelt wird. Hierzu dient eine Meßeinrichtung, die das überwachende Kabel nicht nur auf die Differenz der Betriebskapazität $\Delta C_B$ abprüft, sondern auch auf die Betriebskapazität $C_B$, den Isolationswiderstand $R_{is}$ und den Schliefenwiderstand $R_s$.

Das Verfahren kann bei Kabeln mit Papier- und Kunststofisolierung angewendet werden.

FIG. 1

Fl 4553                          1                          17.04.80

Verfahren und Kabelüberwachungssystem zur automatischen Überwachung eines Fernmeldekabelnetzes

Die Erfindung bezieht sich auf ein Verfahren und ein Kabelüberwachungssystem zur automatischen Überwachung eines Fernmeldekabelnetzes gemäß den Oberbegriffen der Ansprüche 1 und 4.

Die Postverwaltungen als Betreiber von Fernmeldenetzen haben ein großes Interesse daran, den Zustand des Kabelnetzes laufend zu überwachen, um bei Betriebsstörungen möglichst schnell für Abhilfe sorgen zu können. Hierzu wurden zahlreiche automatische Kabelmeßeinrichtungen geschaffen, die im Störungsfall eine Alarmeinrichtung auslösen. Bei diesen Störungsfällen handelt es sich vorwiegend um Isolationsfehler in den Kabeln. Eine automatische Kabelmeßeinrichtung, die die einzelnen Kabel auf Isolationsfehler zyklisch prüft, ist bereits bekannt (Hasler-Mitteilung Nr. 4, 1975, S. 109-113, "Eine neue automatische Kabelmeßeinrichtung"). Diese Meßeinrichtung weist elf Meßbereiche von fünf M$\Omega$ bis 500 M$\Omega$ auf. Mit Leitungsartenschaltern kann je nach Art der Leitung der vorgeschriebene Mindestwert des Isolationswiderstandes festgelegt werden. Im Laufe des Meßvorganges ordnet das Gerät den Isolationswiderstand der angeschlossenen Leitungen in einen der elf Meßbereiche ein. Der resultierende Bereich wird als Meßergebnis einer Steuerung und einem Coder zugeführt. Die Betriebsart und das Meßergebnis sind bestimmend für eine nachgeschaltete Einrichtung, die für ferngesteuertes Prüfen, Alarmieren und Messen vorgesehen ist. Diese Kabelmeßeinrichtung läßt sich jedoch im wesentlichen nur zur Überwachung von papierisolierten Kabeln einsetzen. Neben der Beschränkung auf die Messung des Isolationswiderstandes läßt sich somit auch nur ein bestimmter Kabeltyp erfassen.

Es ist ferner ein Verfahren zur Feststellung von Feuchtigkeit in kunststoffisolierten Nachrichtenkabeln vorgeschlagen worden. Hierbei greift man auf die Erkenntnis zurück, daß die Dielektrizitätskonstante diverser Isolierstoffe frequenzabhängig ist.Daraus ergibt sich z.B., daß die Kapazität eines Kondensators mit geschichteten Isolierstoffen von der verwendeten Meßfrequenz abhängig ist.

Nun steht allerdings nicht so sehr die Betriebsstörung an sich im Vordergrund, sondern die allmähliche Verschlechterung des Betriebszustandes, die üblicherweise nicht unmittelbar erkannt oder geortet werden kann. Dies gilt insbesondere für ungefüllte kunststoffisolierte Kabel, die durch Feuchte- oder Wassereinfluß in ihren Übertragungseigenschaften verschlechtert werden.

Der Erfindung liegt daher die Aufgabe zugrunde, ein Verfahren und ein Kabelüberwachungssystem zur automatischen Überwachung eines Fernmeldekabelnetzes anzugeben, mit dessen Hilfe bereits das beginnende Stadium einer Verschlechterung des Betriebszustandes erkannt und angezeigt wird. Dieses Verfahren soll darüber hinaus nicht nur den Isolationswiderstand eines Kabels ermitteln, sondern alle Werte, die in irgendeiner Form für die beginnende Verschlechterung des Betriebszustandes verantwortlich sind.

Diese Aufgabe wird erfindungsgemäß durch die im kennzeichnenden Teil des Anspruchs 1 angegebenen verfahrenstechnischen Maßnahmen gelöst, wozu ein zur Durchführung des Verfahrens geeignetes Kabelüberwachungssystem im Anspruch 4 angegeben ist.

Die mit der Erfindung erzielbaren Vorteile bestehen darin, daß
das Verfahren eine umfassende Überwachung eines Fernmeldekabelnetzes mit verschiedenen Kabeltypen gestattet und hierbei die
Möglichkeit bietet, bereits das Anfangsstadium einer Verschlechterung zu erkennen und somit rechtzeitig Abhilfemaßnahmen einleiten zu können.

Vorteilhafte Einzelheiten des Verfahrens nach Anspruch 1 sind
den Unteransprüchen 2 und 3, und des Systems nach Anspruch 4
den Unteransprüchen 5 bis 9 zu entnehmen.

Ein Ausführungsbeispiel der Erfindung ist in der Zeichnung dargestellt und wird im folgenden näher beschrieben. Es zeigen:

Fig. 1   die Anschaltung einer Kabelmeßeinrichtung an einen Vierer
Fig. 2   den Einsatz von Kabelmeßeinrichtungen mit einer zentralen
         Überwachungsstelle.

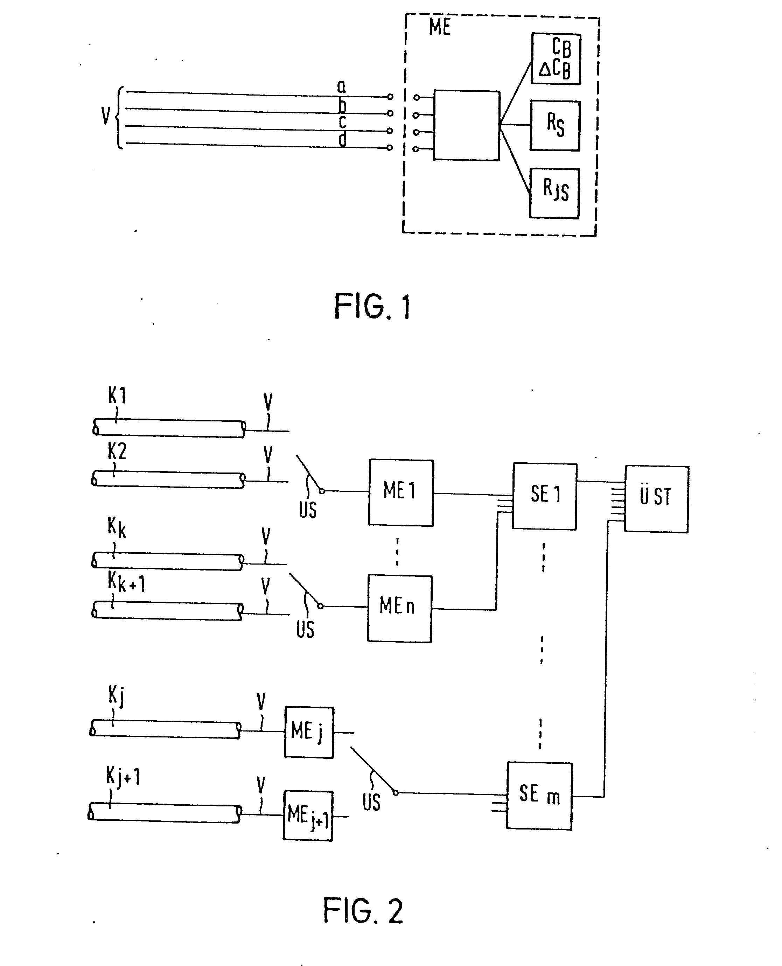

Nach Fig. 1 ist ein Vierer V eines zu überwachenden Kabels mit
seinen Adern a, b, c und d an eine Meßeinrichtung ME angeschlossen.
Diese Meßeinrichtung besitzt drei verschiedene Bausteine zur
Messung des Schleifenwiderstandes $R_S$ (Aderunterbrechung), des
Isolationswiderstandes $R_{Is}$ und der Betriebskapazität $C_B$ bzw.
$\Delta C_B$.

In der Fig. 2 sind Kabel verschiedener Arten, z.B. Orts- und Bezirkskabel an Meßeinrichtungen angeschlossen. Hierbei ist eine
Gruppe von zu überwachenden Kabeln K 1, K 2 jeweils über eine Umschalteinrichtung US mit einer Meßeinrichtung ME 1 verbunden.
Beliebige weitere Gruppen von zu überwachenden Kabeln Kk ...
Kk + 1 sind gleichfalls über Umschalteinrichtungen US an Meßeinrichtungen MEn angekoppelt. Mehrere Gruppen von zu überwachenden
Kabeln werden mit ihren Meßeinrichtungen von einer gemeinsamen
Steuereinheit in bestimmten Zeitabständen aktiviert. Es ist aber
auch denkbar, jeweils ein Kabel Kj mit einer festen Meßeinrichtung MEj, bzw. jedes beliebige weitere Kabel Kj + 1 mit einer festen Meßeinrichtung MEj+1 zu versehen, wobei mehrere Meßeinrichtungen ME dann von einer Steuereinheit SEm bedient werden.
Alle Steuereinheiten SE1 ... SEm stehen mit einer zentralen
Überwachungsstelle ÜSt in Verbindung.

0038400

F1 4553 1 17.04.80

Patentansprüche:

1. Verfahren zur automatischen Überwachung eines Fernmeldekabelnetzes mit Hilfe von Kabelmeßeinrichtungen und automatischen Steuereinrichtungen, d a d u r c h  g e k e n n z e i c h - n e t, daß an den zu überwachenden Kabeln (K) die Differenz der Betriebskapazität ($\Delta C_B$) bei zwei verschiedenen Frequenzen $f_1$ und $f_2$ ermittelt wird, die gemessenen Werte mit vorgegebenen Grenzwerten verglichen werden und die Überschreitung eines Grenzwertes an eine Überwachungsstelle (ÜSt) übermittelt wird.

2. Verfahren zur automatischen Überwachung eines Fernmeldekabelnetzes nach Anspruch 1, d a d u r c h  g e k e n n - z e i c h n e t, daß zusätzlich wahlweise an den zu überwachenden Kabeln (K) der Isolationswiderstand ($R_{is}$) und/oder der Schleifenwiderstand ($R_s$) und/oder die Betriebskapazität ($C_B$) ermittelt werden, die gemessenen Werte mit vorgegebenen Grenzwerten verglichen werden und die Überschreitung eines Grenzwertes an eine Überwachungsstelle (ÜSt) übermittelt wird.

3. Verfahren zur automatischen Überwachung eines Fernmeldekabelnetzes nach einem der Ansprüche 1 oder 2, d a d u r c h  g e k e n n z e i c h n e t, daß der Vergleich der Grenzwerte und die Übermittlung einer Überschreitung an eine Überwachungsstelle (ÜSt) von einer Steuereinheit (SE) durchgeführt wird.

4. Kabelüberwachungssystem zur Durchführung des Verfahrens nach
   Anspruch 3, d a d u r c h  g e k e n n z e i c h n e t,
   daß an jedem zu überwachenden Kabel (K) jeweils eine Meßeinrichtung (ME) installiert ist, die von einer gemeinsamen
   Steuereinheit (SE) in bestimmten Zeitabständen aktiviert
   wird.

5. Kabelüberwachungssystem nach einem der Ansprüche 3 oder 4,
   d a d u r c h  g e k e n n z e i c h n e t, daß mehrere
   Kabel (K) über eine Umschalteinrichtung (US) an einer Meßeinrichtung angeschlossen sind.

6. Kabelüberwachungssystem nach einem der Ansprüche 3 bis 5,
   d a d u r c h  g e k e n n z e i c h n e t, daß die Verbindung zwischen Steuereinheit (SE) und Überwachungsstelle
   (ÜSt) über einen Fernsprechanschluß erfolgt.

7. Kabelüberwachungssystem nach einem der Ansprüche 3 bis 6,
   d a d u r c h  g e k e n n z e i c h n e t, daß mehrere
   Steuereinheiten (SE) an einer gemeinsamen Überwachungsstelle
   (ÜSt) angeschlossen sind.

8. Kabelüberwachungssystem nach einem der Ansprüche 3 bis 7,
   d a d u r c h  g e k e n n z e i c h n e t, daß die Meßeinrichtungen (ME) an nicht belegte Adern der Außenlage
   eines Kabels (K), z. B. Reservevierer angeschlossen sind.

9. Kabelüberwachungssystem nach einem der Ansprüche 3 bis 8,
   d a d u r c h  g e k e n n z e i c h n e t, daß die zu
   überwachenden Kabel (K) Papier- oder Kunststoffisolierung
   aufweisen.

FIG. 1

FIG. 2

**Europäisches Patentamt**

## EUROPÄISCHER RECHERCHENBERICHT

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | DE - A1 - 2 832 643 (SIEMENS)<br>* Seite 3, Zeile 1 bis Seite 4, Zeile 31 *<br>-- | 1 | H 04 M 3/30<br>H 04 B 3/46<br>G 01 R 27/26<br>G 01 R 31/02 |
| | US - A - 3 255 410 (A. NORWICH)<br>* Spalte 1, Zeilen 14 bis 18; Spalte 2, Zeilen 37 bis 47 *<br>-- | 1 | |
| | TELCOM REPORT, Nr. 2, 1979<br>W. WERR et al. "Zentralisiertes Elektronisches Meßsystem für Teilnehmerleitungen und Endgeräte (SULIM)"<br>Seiten 71 bis 75<br>* Seite 72, Tabelle 1, Seite 73, erster Absatz "Gruppenmessung"<br>-- | 1-7 | RECHERCHIERTE SACHGEBIETE (Int. Cl.³)<br><br>G 01 R 27/26<br>G 01 R 31/02<br>H 04 B 3/46<br>H 04 M 3/26<br>H 04 M 3/28<br>H 04 M 3/30 |
| A | DE - B - 1 766 438 (O. VIERLING)<br>* Spalte 2, Zeile 39 bis Spalte 3, Zeile 11 *<br>-- | | |
| D | HASLER-MITTEILUNGEN, Nr. 4, 1975<br>J. DVORAK et al. "Eine neue automatische Kabelmesseinrichtung"<br>Seiten 109 bis 113<br>* Seite 109 *<br>---- | | KATEGORIE DER GENANNTEN DOKUMENTE<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument<br>&: Mitglied der gleichen Patentfamilie, übereinstimmendes Dokument |

| | |
|---|---|
| ✗ | Der vorliegende Recherchenbericht wurde für alle Patentansprüche erstellt. |

| Recherchenort | Abschlußdatum der Recherche | Prüfer |
|---|---|---|
| Berlin | 29-07-1981 | LEMMERICH |

EPA form 1503.1 06.78